# EUROPÄISCHE PATENTANMELDUNG

(11) **EP 0 019 689 A1**
(43) Veröffentlichungstag der Anmeldung: **10.12.1980**
(21) Anmeldenummer: 80101359.0
(22) Anmeldetag: 14.03.1980
(51) Int. Cl.: H04L 1/10

(54) **Verfahren und Schaltungsanordnung zur Überprüfung von aus m Signaladern bestehenden Leitungsbündeln auf das Vorliegen einer Signalmarkierung auf nur einer der Signaladern**

(30) Priorität: 31.05.1979 DE 2922232
(71) Anmelder: SIEMENS AKTIENGESELLSCHAFT, 80333 München (DE)
(72) Erfinder: Katsaros, Damianos, Dipl.-Ing., D-8013 Haar (DE); Bräuer, Gerald, Dipl.-Ing., D-8011 Brunnthal (DE)

(57) **Zusammenfassung**

Überprüfung von aus m Signaladern (z. B. SO bis S7) bestehenden Leitungsbündeln auf das Vorliegen einer Signalmarkierung auf nur einer der Signaladern durch zwei Codierer (COD1, COD2) wobei der eine Codierer (z. B. COD1) eine erste binäre Lageadresse (AD-L) der markierten Signalader mit Bezug auf die Lage im Bündel bei einer vorgegebenen Reihenfolge und der zweite Codierer (COD2) eine zweite binäre Lageadresse (AL-R) der markierten Signalader mit Bezug auf die Lage im Bündel bei entgegengesetzter Reihenfolge ermittelt. Unter der Voraussetzung, daß m = 2ⁿ sowie n > 0 und ganzzahlig ist, muß die invertierte Lageadresse (z. B. AD-R) des einen Codierers (COD2) mit der vom anderen Codierer (COD1) gelieferten Lageadresse (AD-L) übereinstimmen. Dies wird durch Vergleicher (VG1 bis VG3) überprüft, deren Ergebnisse durch nachgeschaltete Verknüpfungsglieder (z. B. ODER-Glied 07) ausgewertet werden.

Das Ergebnis ist eine vorteilhafte. Verknüpfung zwischen einer benötigten Lageumrechnung und einer gleichzeitigen «1 aus m_{"}-Prüfung.

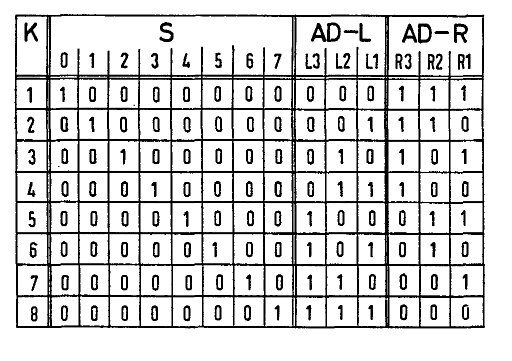

## Beschreibung

Die Erfindung betrifft ein Verfahren und eine Schaltungsanordnung zur Überprüfung von aus m Signaladern bestehenden Leitungsbündeln auf das Vorliegen einer Signalmarkierung auf nur einer der Signaladern, wobei m = 2ⁿ sowie n > 0 und ganzzahlig ist.

In Einrichtungen der Daten- und Nachrichtenverarbeitung besteht häufig die Notwendigkeit, eine sogenannte "1 aus m"-Prüfung vorzunehmen, um sicherzugehen, daß eine parallel über m Signaladern übertragene Signalkombination auch eindeutig ist. Derartige Prüfschaltungen sind allgemein bekannt.

Bei keiner der bekannten Lösungen aber ist es möglich, neben der Prüfung die Lageadresse der markierten Signalader.bereitzustellen. Aufgabe der Erfindung ist es daein her,/Verfahren der eingangs genannten Art und eine nach diesem Verfahren arbeitende Schaltungsanordnung zu schaffen, bei dem bzw. der zugleich mit der Prüfung der bereitgestellten Signalkombination auch die Lageadresse der markierten Signalader erzeugt werden kann, ohne daß dafür zwei voneinander unabhängige Einrichtungen, nämlich ein Codierer und eine Prüfschaltung, vorgesehen werden müssen.

Diese Aufgabe wird bei dem neuen Verfahren gemäß der Erfindung dadurch gelöst, daß die Signaladern des Leitungsbündels der Reihe nach geordnet werden, daß die Lage der markierten Signalader mit Bezug auf die vorgegebene Reihenfolge durch einen ersten Codierer in eine erste binäre Lageadresse und mit Bezug auf die entgegengesetzte Reihenfolge durch einen zweiten Codierer in eine zweite binäre Lageadresse umgewandelt wird,.daß die Ausgangssignale eines der beiden Codierer invertiert werden, daß die Signale einzeln mit den korrespondierenden Ausgangssignalen des anderen Codierers verglichen werden und daß bei Übereinstimmung aller überprüften Signalpaare ein das Vorliegen einer Signalmarkierung nur auf einer der Signaladern des überprüften Leitungsbündels anzeigendes positives Prüfsignal erzeugt wird.

Die Erfindung geht dabei von folgender Erkenntnis aus: Ordnet man die zu überprüfenden Signaladern der Reihe nach , so läßt sich die Lage der jeweils markierten Signalader sehr einfach und in an sich bekannter Weise, wie z.B. in "Integrierte Digitalbausteine" von Reiß, Liedl, und Spichall, Siemens AG, 1970, Seiten 272 und 273 gezeigt ist, durch eine binäre Adresse angeben. Dabei bestehen zwei Möglichkeiten, man wählt entweder das eine oder das andere Ende der vorgegebenen Reihenfolge als Ausgangspunkt, so daß je Signalkombination zwei voneinander abweichende Binärwerte als Lageadresse möglich sind. Erfüllt dabei die Zahl m der zu überprüfenden Signaladern die Bedingung m = 2ⁿ, so ergibt sich ein sehr einfacher Zusammenhang zwischen beiden Adressen: Jede Adresse bildet nämlich das Komplement zur jeweils anderen und unabhängig von der ersten ermittelten Adresse, so daß sich jede Adresse durch Invertieren in die jeweils komplementäre Adresse überführen läßt. Dieser Zusammenhang wird für die "1 aus m"-Prüfung ausgenutzt, indem durch Vergleich festgestellt wird, ob die eine Lageadresse mit der invertierten anderen Lageadresse übereinstimmt.

Gemäß dem neuen Verfahren werden also Erzeugung der Lageadresse und Prüfung auf Eindeutigkeit der anstehenden Signalkombination in vorteilhafter Weise miteinander verknüpft. Dabei ist es möglich, daß gemäß einer Weiterbildung der Erfindung bei Vorliegen des positiven Prüfsignales die von dem einen Codierer gelieferte binäre Lageadresse für die weitere Verarbeitung 'freigegeben wird.

Die Schaltungsanordnung zur Durchführung des Verfahrens gemäß der Erfindung ist gekennzeichnet durch zwei Codierer zur Erzeugung von binären Lageadressen, von denen sich eine auf die Lage der markierten Signalader bei einer vorgegebenen Reihenfolge und die andere sich auf die Lage der markierten Signalader bei einer zu der vorgegebenen Reihenfolge umgekehrten Reihenfolge bezieht, durch n Inverter zur Invertierung der Ausgangssignale des einen Codierers, durch n Vergleicher für den paarweisen Vergleich der Ausgangssignale der Inverter mit den korrespondierenden Ausgangssignalen des anderen Codierers und durch ein.Verknüpfungsglied für die Ableitung des positiven Prüfsignales aus den Ausgangssignalen aller Vergleicher.

Der Aufwand für eine derartige Schaltungsanordnung ist also verhältnismäßig gering. So können die benötigten Codierer aus n ODER-Gliedern mit m/2 Eingängen bestehen. Die Vergleicher können als Exkulisiv-ODER-Glieder ausgebildet sein, wobei das Verknüpfungsglied ein ODER-Glied mit negierten Ausgang ist.. Daneben können gemäß einer Weiterbildung der Erfindung weitere Verknüpfungsglieder zur Erzeugung von das Vorliegen einer Signalmarkierung auf einer von 1 abweichenden Anzahl von Signaladern anzeigenden Prüfsignalen vorgesehen sein.

Weitere Einzelheiten der Erfindung seien nachfolgend anhand eines in der Zeichnung dargestellten Ausführungsbeispieles näher erläutert. Im einzelnen zeigen
FIG 1 eine Tabelle zur Ableitung der Lageadressen und
FIG 2 ein Schaltungsbeispiel.

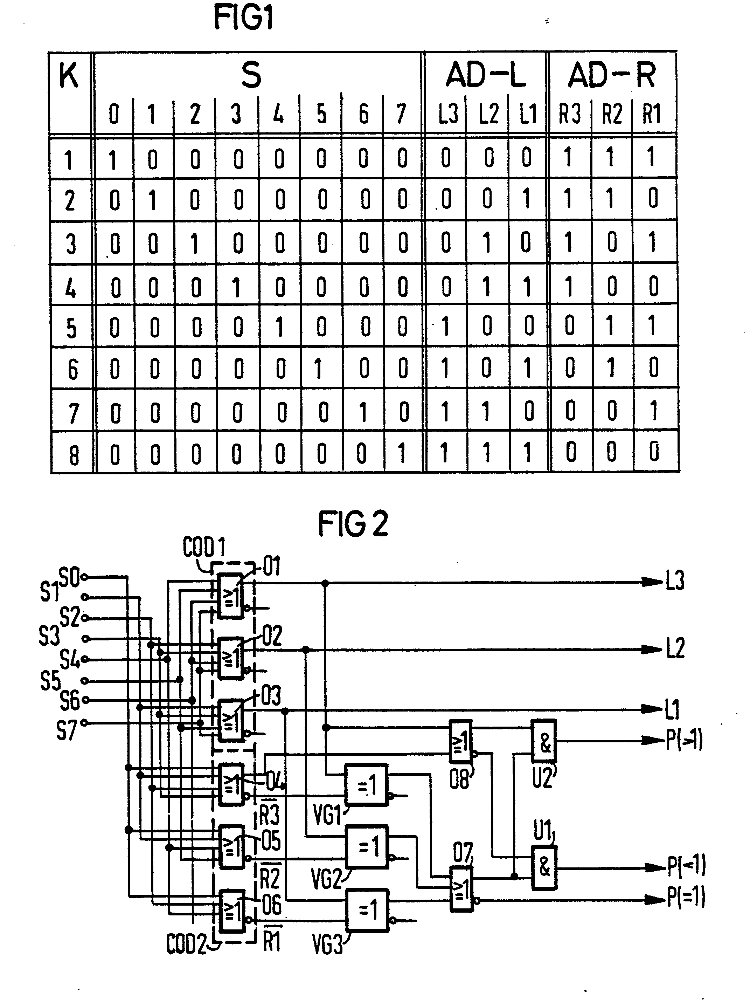

Im-linken Teil der Tabelle nach FIG 1 sind entsprechend der als Beispiel gewählten acht Signaladern SO bis S7 acht Spalten vorgesehen, in die entsprechend den möglichen acht unterschiedlichen Signalkombinationen K1 bis K8 die zugehörigen Signalmarkierungen "1" eingetragen sind, während eine "0" das Fehlen einer Signalmarkierung anzeigt. So führt beispielsweise bei der Signalkombination K1 die Signalader SO ein Markierungssignal, während alle übrigen Signaladern S1 bis S7 markierungsfrei sind.

Im rechten Teil der Tabelle sind in den Spalten AD-L und AD-R die die Lage der markierten Signalader innerhalb der vorgegebenen Reihenfolge angebenden beiden Binäradressen zu jeder Signalkombination K1 bis K8 aufgeführte Diese Adresse bestehen jeweils aus drei Bit L1, L2 und L3 bzw. R1, R2 und R3 mit steigender Stellenwertigkeit. Die Adressen der Spalte AD-L werden erhalten, wenn man die Lage der jeweils markierten Signalader innerhalb.der vorgegebenen Reihenfolge von links aus berechnet. Analoges gilt für die Adressen der Spalte AD-R, wenn man von rechts aus rechnet. Infolge der Bedingung m = 2ⁿ sind die Adressenpaare je Signalkombination zueinander komplementär, wie ein Vergleich der beiden Adressenspalten zeigt.

Die notwendigen Verknüpfungen zur Ableitung der einzelnen Bitstellen beider Binäradressen ergeben sich bekanntlich nach folgenden Beziehungen:

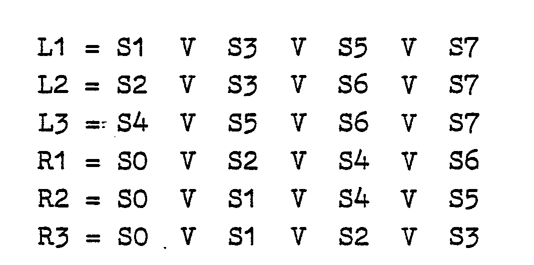

Je Codierer sind also im einfachsten Falle drei ODER-Glieder mit jeweils m/2 = 4 Eingängen erforderlich.

Eine entsprechende Schaltungsanordnung zeigt FIG 2 mit den ODER-Glieder 01 bis 03 des Codierers COD1 und den ODER-Gliedern 04 bis 06 des Codierers COD2. Die Ausgänge der ODER-Glieder 01 bis 03 liefern unmittelbar die Lageadresse der jeweils markierten Signalleitung mit den Bitstellen L1 bis L3, die für die weitere Verarbeitung verwendet wird. Die ODER-Glieder 04 bis 06 liefern über die negierten Ausgänge unmittelbar die Bitstellen R̅1̅ bis R̅3̅ der Vergleichsadresse.

Die Bitstellen beider Binäradressen werden anschließend paarweise miteinander durch die Vergleicher VG1 bis VG3 auf-Übereinstimmung überprüft. Diese Vergleicher sind beim Ausführungsbeispiel als Exklusiv-ODER-Glieder ausgebildet, die nur bei einer logischen "1" an einem der Eingänge, also bei Ungleichheit der Eingangssignale, ansprechen. Die Ausgangssignale werden daher durch ein ODER-Glied 07 überprüft, an dessen negierten Ausgang das positive Prüfsignal P₍₌₁₎ abgeleitet wird.

Der andere Ausgang des ODER-Gliedes 07 zeigt an, daß eine Adressenungleichheit besteht. Diese kann dadurch bedingt sein, daß entweder keine der Signaladern oder aber mehr als eine der Signaladern markiert ist. Das zusätzliche ODER-Glied 08 dient zur Unterscheidung dieser beiden Möglichkeiten, indem es die Ausgänge der ODER-Glieder 01 und 04 überwacht, durch die alle Signaladern SO bis S7 entsprechend den Verknüpfungsgleichungen für die Bitstellen L3 und R3 erfaßt werden.

Liefert das ODER-Gatter 08 am nichtnegierten Ausgang ein Signal, so ist wenigstens eine der zu überprüfenden Signaladern SO bis S7 markiert. In Verbindung mit dem Signal am nichtnegierten Ausgang des ODER-Gliedes 07 ist damit über das UND-Glied U2 eine eindeutige Aussage P_{(> 1)} möglich, der zufolge mehr als eine Signalader markiert ist. Liefert das ODER-Gatter 08 über seinen negierten Ausgang ein Signal, so ist in Verbindung mit dem Signal am nichtnegierten Ausgang des ODER-Gliedes 07 eine Aussage P_{(<1)} möglich, die besagt, daß keine Signalader markiert ist..

Insgesamt ergibt sich so eine sehr einfache, aus Standardverknüpfungsgliedern aufgebaute chaltungsanordnung, die den verschiedensten Betriebsbedingungen angepaßt werden kann. Dabei sind eine Reihe von Abwandlungen denkbar, ohne daß das zugrundeliegende Lösungsprinzip dadurch beeinträchtigt wird. So könnte z.B. das ODER-Glied 07 durch ein UND-Glied ersetzt werden, wenn die negierten Ausgangssignale der Exklusiv-ODER-Glieder VG1 bisVG3 als Eingangssignale verwendet würden. Weiterhin könnten anstelle der Exklusiv-ODER-Glieder Äquivalenzglieder als Vergleicher verwendet werden usw.: Entscheidend ist lediglich, daß bei allen Varianten der logische Verknüpfungszusammenhang entsprechend dem neuen Verfahren gewahrt bleibt.

## Patentansprüche

1. Verfahren zur Überprüfung von aus m Signaladern bestehenden Leitungsbündeln auf das Vorliegen einer Signalmarkierung auf nur einer der Signaladern, wobei m = 2ⁿ sowie n > 0 und ganzzahlig ist, dadurch gekennzeichnet , daß die Signaladern (z.B. SO bis S7) des Leitungsbündels der Reihe nach geordnet werden, daß die Lage der markierten Signalader (z.B. SO) mit Bezug auf die vorgegebene Reihenfolge durch einen ersten Codierer (COD1) in eine erste binäre Lageadresse (AD-L) und mit Bezug auf die entgegengesetzte Reihenfolge durch einen zweiten Codierer (COD2) in eine zweite binäre Lageadresse (AD-R) umgewandelt wird, daß die Ausgangssignale eines der beiden Codierer (z.B. COD2) invertiert werden, daß diese Signale (R̅1̅, R̅2̅ und R3) mit den korrespondierenden Ausgangssignalen (L1, L2 und L3) des anderen Codierers (COD1) verglichen werden und daß bei Übereinstimmung aller überprüften Signalpaare (z.B. L5 und R̅3̅) ein das Vorliegen einer Signalmarkierung nur auf einer der Signaladern (SO bis S7) des überprüften Leitungsbündels anzeigendes positives Prüfsignal (P₍₌₁₎) erzeugt wird.

2. Verfahren nach Anspruch 1, dadurch gekennzeichnet, daß bei Vorliegen des positiven Prüfsignales (P₍₌₁₎) die von dem einen Codierer (z.B. COD1) gelieferte binäre Lageadresse für die weitere Verarbeitung freigegeben wird.

3. Schaltungsanordnung zur Durchführung des Verfahrens nach Anspruch 1 oder 2, gekennzeichnet durch zwei Codierer (COD1 und COD2) zur Erzeugung von binären Lageadressen (AD-L bzw. AD-R), von denen sich eine (z.B. AD-L) auf die Lage der markierten Signalader Kt 1 Stl / 18.5.79
(z.B. SO) bei einer vorgegebenen Reihenfolge und die andere (AD-R) sich auf die Lage der markierten Signalader bei einer zu der vorgegebenen Reihenfolge umgekehrten Reihenfolge bezieht, durch n Inverter zur Invertierung der Ausgangssignale des einen Codierers (z.B. COD2), durch n Vergleicher (z.B. VG1 bis VG3) für den paarweisen Vergleich der Ausgangssignale der Inverter (z.B. R̅1̅, R̅2̅ und R3) mit den korrespondierenden Ausgangssignalen (z.B. L1,.L2 und L3) des anderen Codierers (COD1) und durch ein Verknüpfungsglied (z.B. ODER-Glied 07) für die Ableitung des positiven Prüfsignales (P₍₌₁₎) aus den Ausgangssignalen aller Vergleicher (z.B. VG1 bis VG3).

4. Schaltungsanordnung nach Anspruch 3, dadurch gekennzeichnet , daß die Codierer (COD1 und COD2) aus n je ODER-Gliedern (z.B. 01 bis 03 bzw. 04 bis 06) mit m/2 Eingängen bestehen.

5. Schaltungsanordnung nach Anspruch 3 oder 4, dadurch gekennzeichnet , daß die Vergleicher (z.B. VG1 bis VG3) Exklusiv-ODER-Glieder sind und daß das Verknüpfungsglied ein ODER-Glied (07) mit negiertem Ausgang ist.

6. Schaltungsanordnung nach einem der Ansprüche 3 bis 5, dadurch gekennzeichnet , daß weitere Verknüpfungsglieder (z.B. ODER-Glied 08 und UND-Glieder U1 und U2) zur Erzeugung von das Vorliegen einer Signalmarkierung auf einer von 1 ' abweichenden Anzahl von Signaladern. anzeigenden Prüfsignalen (P_{(< 1)} oder P_{(> 1)}) vorgesehen sind.
